# EUROPEAN PATENT SPECIFICATION

(11) **EP 0 565 154 B1**
(45) Date of publication and mention of the grant of the patent: **03.06.1998**
(21) Application number: 93200683.6
(22) Date of filing: 10.03.1993
(51) Int. Cl.: G03F 1/00, G03C 1/95

(54) **Gelatinous drafting material**
Gelatinöses Aufzeichnungsmaterial
Matériau pour dessiner gélatineux

(30) Priority: 10.04.1992 EP 92201030
(43) Date of publication of application: 13.10.1993
(73) Proprietor: AGFA-GEVAERT N.V., 2640 Mortsel (BE)
(72) Inventor: Boeykens, Jozef, B-2640 Mortsel (BE); Van Thillo, Etienne, B-2640 Mortsel (BE); Andries, Hartwig, B-2640 Mortsel (BE)

(56) References cited:
- EP-A- 0 212 673
- GB-A- 2 026 201
- US-A- 3 589 905
- US-A- 3 627 563

## Description

### 1. Field of the invention.

The present invention relates to a gelatinous drafting material for use in industrial engineering.

### 2. Background of the invention.

Drafting materials are widely used in private or public engineering bureaus for widely varying applications such as cartography, building constructions, public utility schemes (e.g. gas, water), design of industrial installations, automobiles, planes, missiles and various consumer goods such as furniture and toys.

A considerable part of the market is still occupied by the conventional application of manual drawing of sketches. After the creative design phase these sketches can be duplicated on photographic material, on diazo materials or by means of a large format copying machine (i. a. marketed by XEROX Co) in which latter case the same drafting film stock can be used as duplicating material.

In a modern alternative of work flow the creative phase is performed on computer by so-called Computer Aided Design (CAD) after which the final drawing is stored in digitized form. In this case the drafting material is used as recording material for this digitized information the output of which is performed mechanically by a so-called pen plotter, or by a so-called laser plotter (e.g. the VERSATEC system, marketed by VERSATEC-XEROX), operating in a way similar to a laser printer. According to still another application the drafting film can be used as recording material for an ink jet apparatus. After the plotting the resulting drawings can be duplicated by the same means as the ones cited above for the manual way of drafting.

A modern drafting material must comply with the property requirements put forward by its use both as manual drawing medium and as plotter recording material.

First of all such a material must show a sufficient abrasive power in order to ensure take up of pencil graphite; further it must show good absorption properties for drawing ink. On the other hand the abrasive power may not be too high in order to avoid premature wearing of pencil or pen points. Furtheron the drawn lines and characters should be easily erased by conventional pencil or ink gums. In particular, the appearance on gumming of so-called "ghost lines", consisting of rest lines appearing dark in reflection and clear in transmission, should be avoided. On the other hand the erased spots should be perfectly rewritable. In other words the drafting material should withstand several retouching operations without getting damaged or giving a messy appearance.

Furtheron the diffusion of ink of freshly drawn lines should be restricted to a minimum so that sharp lines are produced without irregular or diffuse edges. In this way even after copying a high resolution drawing is retained.

The drafting material should exhibit a certain degree of reflection in order to give a clear contrast on visual inspection. The outlook should be neutral white and uniform. On the other hand the material should be enough transmissive to allow duplicating by the methods cited above.

A drafting film serving as recording material for a pen plotter system requires excellent anti static properties especially if the pen of the plotter remains in a fixed position and the material itself is moved in several successive directions.

When using the drafting film as recording medium for a laser plotter or as duplicating medium in a copying apparatus the material ought to be able to withstand elevated temperature due to thermofixation of the electrostatic toner image without being damaged or curled or undergoing excessive dimensional change. In other words the material need to be thermostable.

Several drafting films are present on the market with excellent properties, e.g. the materials marketed by RHONE-POULENC Co, by FOLEX Co. by OCE Co. by KEUFEL & ESSER Co and by ICI Co. However from their composition determined by analysis it is clear that their drafting layer is coated from an organic solvent medium, usually containing polymethylmethacrylate as the ingredient which makes the layer resistant to abrasion. For a photo-industrial company like the assignee of the present application this way of production presents a double inconvenience. First of all coating from organic solvents requires special installations and is for this reason more expensive than conventional coating from aqueous colloidal solutions. Secondly use of organic solvents in a production process poses ecological problems and requires special precautions making it even more expensive.

It is an object of the present invention to provide a drafting material which can be coated from an aqueous colloidal solution in an economic and ecologically safe way.

It is a further object of the present invention to provide a drafting material which shows a sufficient but not excessive abrasive power, which is capable of rendering fine ink lines, whose drawings can be easily duplicated and which can withstand several retouching operations.

It is still a further object to provide a drafting material which is thermostable for those applications where elevated temperatues occur.

Other objects from the present invention will become clear from the summary and description hereafter.

### 3. Summary of the invention.

The objects of the present invention are realized by providing a drafting material comprising a transparent support and at least one hydrophilic colloidal layer containing :
(a) gelatin ;
(b) one or more silica matting agents ;
(c) an opacifying agent ;
(d) an epoxysilane compound ;
(e) a polyurethane ;
(f) a hardening agent.

Although the separate use of these ingredients in hydrophilic coated layers is known it is this particular combination which unexpectedly gives this drafting layer its excellent physical sturdiness, making it suitable fot repeated drawing and retouching operations. The hydrophilic layer can be coated on one side or on both sides of the support.

Preferably the transparent support is an organic polymeric resin, e.g. polyethylene terephtalate. This support has preferably been subjected to a thermorelaxation treatment for those applications of the drafting film where elevated temperature can occur.

### 4. Detailed description of the invention.

The gelatin used in the drafting layer of this invention can be lime-treated or acid-treated gelatin. The preparation of such gelatins has been described in e.g. "The Science and Technology of Gelatin", edited by A.G. Ward and A. Courts, Academic Press 1977, page 296 and next pages. The gelatin can show a low or a high iso-electric point. It can belong to the low or high viscosity type. The gelatin for use in the colloidal drafting layer of the present invention is preferably a mixture of low and high viscosity type, the latter being present in majority. It is such a mixture which gives the layer the best mechanical strength and a quick reaching of the final hardening properties after coating. The dry coverage of the gelatin in the drafting layer preferably ranges from 1.0 g/m² to 10 g/m² and most prefebly between 1.5 and 3.0 g/m².

The use of silica matting agents in drafting materials is well-known in the art, e.g. from US 3,370,951, US 4,366,239, US 4,588,673 and US 4,610,924. The silica can belong to the crystalline or amorphous type. In the practice of this invention the use of a mixture of both types is particularly preferred. The crystalline silica preferably shows an average particle size from 1 to 5 micrometers. The crystalline type gives the layer its matt appearance and its minimal abrasive power to ensure good uptake of pencil graphite. It is preferably added to the coating solution as a gelatinous dispersion giving rise to a perferred concentration range in the dry layer between 1.0 and 5.0 g/m². The presence of amorphous silica is thought to be favourable for retouching pencil and-ink lines ; it makes the layer more suited for rewriting after gumming. Like the crystalline type the amorphous silica is preferably added as a gelatinous dispersion giving rise to a concentration in the dry layer preferably between 0.2 and 2.0 g/m².

As opacifying agent preferably titanium dioxide is used as it is the case in many industrial applications. The rutile crystal modification produces a faint yellowish hue in the dry drafting layer due to its minor absorption of blue light just above 400 nm. So when using rutile titanium dioxide it is advisable to include some amounts of (a) blue dye(s) in the layer in order to readjust the color hue to neutral. Therefore it is preferred to use titanium dioxide of the anatase crystal modification which is almost perfectly white and does not need colour correction by dyes. The pigment is added preferably in a concentration between 0.2 and 0.4 g/m² so that the tranmission of a double side coated material is between 30 % and 50 % measured with a MACBETH TD 904 spectrophotometer.

An epoxysilane is incorporated in the gelatinous drafting layer. A particularly preferred epoxysilane (type DC 6040, manufactured by DOW CORNING Co) is represented by formula (E-1) :

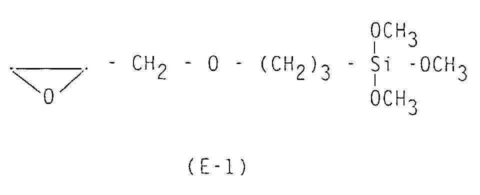

The epoxysilane improves the physical sturdiness of the dried hydrophilic drafting layer. It was demonstrated experimentally that the resistance to damage by repeated gumming was drastically improved by the incorporation of the epoxysilane and this as well for dry as for wet ink gumming. The epoxysilane is preferably added to the coating liquid as an alcoholic solution. Its concentration in the layer Is preferably comprised between 0.1 and 0.4 g/m².

A further essential ingredient in the colloidal drafting layer used in this invention is a polyurethane, preferably an aliphatic anionic polyurethane dispersion. An especially preferred polyurethane for use in accordance with the present invention is commercially available under the trade name IMPRANIL 43056, manufactured by BAYER Co. The polyurethane is added to the coating solution as a aqueous latex dispersion. This polyurethane counteracts the abrasive action of the silica matting agents in the drafting layer and is used to adjust this abrasive power to an optimal value. Furtheron it was shown experimentally that the presence of the polyurethane latex was very important in the suppression of "ghost lines" as defined above. To be effective the polyurethane must occupy about 20 % to 40 % of the dry weight of the hydrophilic drafting layer.

The gelatin binder of the photographic elements can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binder can also be hardened with fast-reacting hardeners (so-called instant hardeners) such as carbamoylpyridinium salts as disclosed in US 4,063,952 and with the onium compounds as disclosed in European Patent Application No 90.201850.6.

A preferred hardener for the hydrophilic gelatinous drafting layer is 1,3,5-triacroyl-hexahydro-s.triazine, represented by following formula (H-1) :

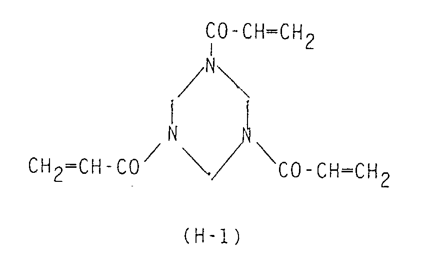

However for the particular application of the drafting material as subcoat for the further production of a wash-off material special attention must be given to the choice of the hardening agent since in this case no hardener is allowed to diffuse from the subcoat to the wash-off layer which should only be hardened image-wise by tanning development. In this case instant hardeners, e.g. carbamoyl pyridinium salts are preferred.

The gelatinous drafting layer may further contain a brightening agent. By its fluorescent action such a compound enhances the visual contrast on inspection of the drawings. A preferred compound is represented by formula B-1) :

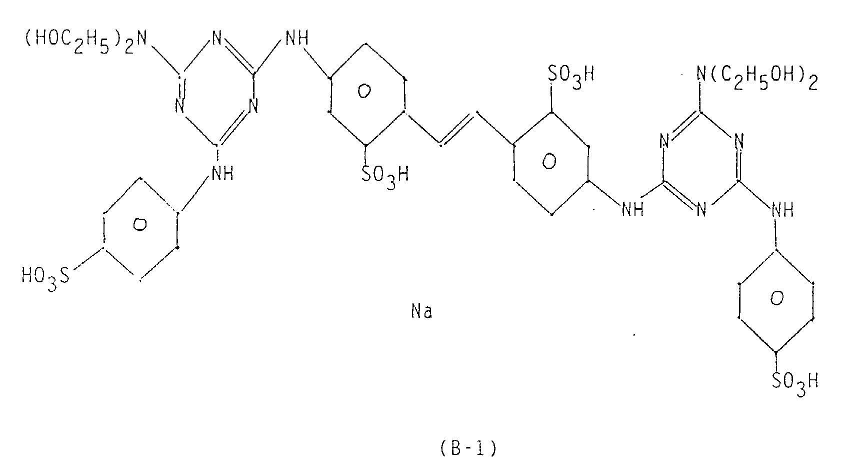

The gelatinous drafting layer can further contain one or more antistatic agents, preferably incorporated in the subbing layer.

The drafting material of the present invention may further comprise various kinds of surface-active agents. Suitable surface-active agents include non-ionic agents such as saponins, alkylene oxides e.g. polyethylene glycol, polyethylene glycol glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges or as compounds improving slidability. Preferred agents are compounds containing perfluorinated alkyl groups.

The hydrophilic layer of the drafting material of the present invention may further comprise various other additives such as e.g. compounds improving the dimensional stability and plasticizers. Suitable additives for improving the dimensional stability of the photographic element are e.g. dispersions of a water-soluble or hardly soluble synthetic polymer e.g. polymers of alkyl(meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The support of the drafting material of the present invention is preferably a transparent organic resin support e.g. cellulose nitrate film, cellulose acetate film, polyvinyl acetal film, polystyrene film, polyethylene terephthalate film, polycarbonate film, polyvinylchloride film or poly-Alpha-olefin films such as polyethylene or polypropylene film. In a preferred embodiment the support is clear polyethylene terephtalate, the thickness of wich can be varied according to the particular application of the drafting film. Most preferably a set of at least three different thicknesses, respectively 75 micrometers, 100 micrometers, and 125 micrometers is provided. The polyethylene terephtalate support is preferably provided with a primer and a subbing layer in order to ensure good ahhesion of the hydrophilic drafting layer.

The polyethylene terephtalate support preferably has been subjected to a thermorelaxation treatment in order to be able to withstand elevated temperatures on thermofixation. This is realized by incorporating a controlled shrinkage process in the on-line production of the support.

The gelatinous layer can be provided with a protective layer although this is not strictly needed. If present the protective layer preferably contains colloidal silica which is favourable for further suppession of "ghost lines" on gumming.

The gelatinous drafting layer can be coated on only one side of the support, but most preferably it is applied on both sides.

The following examples illustrate the present invention without however being limited thereto.

### EXAMPLE 1

A coating solution was prepared as follows. To 625 ml of demineralized water at 40 °C were added 25 g of gelatin of the high viscosity type and the mixture was stirred until dissolution. 60 g of a dispersion containing 25.1 g of crystalline silica particles, showing an average diameter of 2 micrometers, and 2.5 g of gelatin of the low viscosity type were added. Further were added 10 g of a dispersion containing 3.75 g of titanium dioxide of the anatase modification and 0.56 g of gelatin of the low viscosity type. Furtheron 75 g of a 11.25 % dispersion were added containing 8.4 g of amorphous silica with an average particle diameter of 3.7 micrometers, 5.0 g of gelatin of the low viscosity type, and 4.1 g of polyethylethacrylate. After dissolution of the dispersions 40 ml of a 10 % ethanolic solution of epoxysilane (type DC 6040 of DOW CORNING, compound E-1) were added and the mixture was stirred for 30 min. As wetting agents, 8 ml- of a 9 % aqueous-ethanolic (80/20) solution of commercial surfactant ULTRAVON W, and 2 ml of a 5 % aqueous solution of a polyethyleneoxide surfactant containing perfluorinated alkyl groups were used. As hardening agent 100 ml of a 2.5 % solution (methanol/water ; 70/30) of 1,3,5-triacroyl-hexahydro-s.triazine (compound H-1) were added. As brightening agent 0.75 ml of a 6 % aqueous solution of compound B-1 (see Description) were used. Finally 75 ml of a 45 % (by weight) polyurethane latex (trade name IMPRANIL 43056 ; BAYER) were added. The pH of the mixture was adjusted to 8.0 with a minor amount of a sodium hydroxide solution, and the volume was adjusted to 1 liter with demineralized water.

The thus prepared solution was coated by slide hopper coating technique on one side of a transparent polyethylene terephtalate base of 100 micrometers thickness at a coverage of 7.31 g/m². This base was provided with a primer layer comprising 80 % by weight of Co⁻(vinylidenechloride/methacrylate/itaconic acid ; 88/10/2)-polymer and 20 % by weight of colloidal silica. Upon the prime layer was provided a subbing layer containing about 50 % gelatin, about 50 % of colloidal silica and a minor amount of polymethylacrylate spherical beads. After coating the hydrophilic colloidal drafting layer was dried in a conventional way. After 14 days the material was subjected to some standard physical and drawing tests. The adhesion to the suport was all right. The density of pencil and ink lines was sufficient and in the latter case no line broadening occurred. The optical density of the layer was about 0.30. No "ghost lines" appeared upon gumming.

### EXAMPLE 2

The same hydrophilic colloidal coating solution as in example 1 was coated on both sides of the support. Excellent physical and drawing properties were obtained.

## Claims

1. Drafting material comprising a transparent support and at least one hydrophilic colloidal layer containing :
(a) gelatin ;
(b) one or more silica matting agents ;
(c) an opacifying agent ;
(d) an epoxysilane compound ;
(e) a polyurethane ;
(f) a hardening agent.

2. Drafting material according to claim 1 wherein said opacifying agent is titanium dioxide.

3. Drafting material according to claim 2 wherein said titanium dioxide is of the anatase crystal modification.

4. Drafting material according to any of claims 1 to 3 wherein said silica matting agents consist of a mixture of crystalline and amorphous silica.

5. Drafting material according to any of claims 1 to 4 wherein siad hydrophilic colloidal layer further contains a brightening agent.

6. Drafting material according to any of claims 1 to 5 wherein said support is a polyetylene terephtalate support.

7. Drafting material according to claim 6 wherein said polyethylene terephtalate support had been subjected to a thermorelaxation treatment.

8. Drafting material according to any of claims 1 to 7 wherein said hydrophilic colloidal layer is coated on both sides of said support.

## Patentansprüche

1. Aufzeichnungsmaterial mit einem transparenten Träger und wenigstens einer hydrophilen, die nachstehenden Ingredienzen enthaltenden Kolloidschicht :
(a) Gelatine,
(b) ein oder mehrere Kieselerdemattiermittel,
(c) ein Trübungsmittel,
(d) eine Epoxysilanverbindung,
(e) ein Polyurethan,
(f) einen Härter.

2. Aufzeichnungsmaterial nach Anspruch 1, dadurch gekennzeichnet, daß das Trübungsmittel Titandioxid ist.

3. Aufzeichnungsmaterial nach Anspruch 2, dadurch gekennzeichnet, daß das Titandioxid der Anatasekristallmodifikation ist.

4. Aufzeichnungsmaterial nach irgendeinem der Ansprüche 1 bis 3, dadurch gekennzeichnet, daß die Kieselerdemattiermittel aus einer Mischung aus kristalliner und amorpher Kieselerde bestehen.

5. Aufzeichnungsmaterial nach irgendeinem der Ansprüche 1 bis 4, dadurch gekennzeichnet, daß die hydrophile Kolloidschicht weiterhin ein optisches Aufhellmittel enthält.

6. Aufzeichnungsmaterial nach irgendeinem der Ansprüche 1 bis 5, dadurch gekennzeichnet, daß der Träger ein Polyethylenterephthalatträger ist.

7. Aufzeichnungsmaterial nach Anspruch 6, dadurch gekennzeichnet, daß der Polyethylenterephthalatträger einer Thermorelaxationsbehandlung unterzogen worden ist.

8. Aufzeichnungsmaterial nach irgendeinem der Ansprüche 1 bis 7, dadurch gekennzeichnet, daß die hydrophile Kolloidschicht auf beiden Seiten des Trägers vergossen ist.

## Revendications

1. Matériau à dessin comprenant un support transparent et au moins une couche colloïdale hydrophile contenant:
(a) de la gélatine;
(b) un ou plusieurs agents de matage de silice;
(c) un agent opacifiant;
(d) un composé d'époxysilane;
(e) un polyuréthanne;
(f) un durcisseur.

2. Matériau à dessin selon la revendication 1, dans lequel ledit agent opacifiant est le dioxyde de titane.

3. Matériau à dessin selon la revendication 2, dans lequel ledit dioxyde de titane représente la modification cristalline anatase.

4. Matériau à dessin selon l'une quelconque des revendications 1 à 3, dans lequel lesdits agents de matage de silice sont constitués d'un mélange de silice cristalline et de silice amorphe.

5. Matériau à dessin selon l'une quelconque des revendications 1 à 4, dans lequel ladite couche colloïdale hydrophile contient en outre un agent de blanchiment optique.

6. Matériau à dessin selon l'une quelconque des revendications 1 à 5, dans lequel ledit support est un support de polyéthylènetéréphtalate.

7. Matériau à dessin selon la revendication 6, dans lequel ledit support de polyéthylènetéréphtalate a été soumis à un traitement de thermorelaxation.

8. Matériau à dessin selon l'une quelconque des revendications 1 à 7, dans lequel ladite couche colloïdale hydrophile est enduite sur les deux faces dudit support.
